# EUROPÄISCHE PATENTSCHRIFT

(11) **EP 1 905 040 B1**
(45) Veröffentlichungstag und Bekanntmachung des Hinweises auf die Patenterteilung: **02.12.2009**
(21) Anmeldenummer: 06777759.9
(22) Anmeldetag: 13.07.2006
(51) Int. Cl.: G11C 5/00

(54) **VERFAHREN ZUR HERSTELLUNG VON SPEICHERMODULEN**
METHOD FOR PRODUCING MEMORY MODULES
PROCEDE POUR PRODUIRE DES MODULES MEMOIRE

(30) Priorität: 20.07.2005 DE 102005034494
(43) Veröffentlichungstag der Anmeldung: 02.04.2008
(73) Patentinhaber: Endress+Hauser Conducta Gesellschaft für Mess- und Regeltechnik mbH+Co. KG, 70839 Gerlingen (DE)
(72) Erfinder: ROBL, Stefan, 70839 Gerlingen (DE); VICARI, Angelo, 70839 Gerlingen (DE)
(74) Vertreter: Andres, Angelika Maria
(86) Internationale Anmeldenummer: PCT/EP2006/064206
(87) Internationale Veröffentlichungsnummer: WO 2007/009939

(56) Entgegenhaltungen:
- US-A- 5 157 829
- US-A1- 2002 112 119
- US-B1- 6 240 635

## Beschreibung

Die Erfindung betrifft ein Verfahren zur Herstellung von Speichermodulen.

In der Prozessautomatisierungstechnik werden vielfach Messumformer eingesetzt, die Speichermodule zur Speicherung von Parametrierdaten, Log-Bücher, etc. aufweisen. Diese Speichermodule bestehen in der Regel aus Flash-Speicherbausteinen, die zusammen mit weiteren Komponenten auf Platinen angeordnet sind.

Die Speicherkapazität der eingesetzten Speicherbausteine ist verhältnismäßig groß, sie kann unter Umständen mehr als 16 MB betragen.

Bei der Fertigung eines Messumformers insbesondere bei der Bestückung der Elektronikmodule müssen diese Speicherbausteine programmiert werden. Aufgrund der hohen Speicherkapazität ist die Programmierung sehr zeitaufwendig. Die Programmierzeit (ca. 1-5 Minuten) für einen Speicherbaustein liegt erheblich höher als die Bestückungszeit für andere Bauteile. Dies bedeutet eine erhebliche Verzögerung bei der Bestückung der Platinen aufgrund der notwendigen Programmierung der Speicherbausteine. Insbesondere beim Einsatz von teuren und damit schnellen Bestückungsautomaten bei der Montage von Elektronikmodulen sind solche Verzögerungen sehr nachteilig.

Der Bestückungsautomat muss abwarten, bis der betreffende Speicherbaustein programmiert ist. Erst danach kann die Platine mit dem Speicherbaustein und weiteren Bauteilen bestückt werden.

Heutzutage werden Speicherbausteine über spezielle Programmiergeräte (z.B. Roadrunner, Fa. Data IO) vor der eigentlichen Bestückung der Platinen programmiert. Es ist möglich, vier Speicherbausteine mit einem solchen System parallel zu programmieren und anschließend dein Aufnahmepunkt eines Bestückungsautomaten zuzuführen.

Die stets wachsende Speicherkapazität der Speicherbausteine führt sicherlich zu weiteren Verzögerungen aufgrund des Programmiervorgangs. Trotz der heute bekannten parallelen Programmierung von vier Speicherbausteinen kommt es bei der Montage der Elektronikmodule zu Verzögerungen.

Eine Möglichkeit derartige Verzögerungen prinzipiell zu umgehen besteht darin, Speicherbausteine einzusetzen, die vom Hersteller bereits vorprogrammiert sind. Hierbei können jedoch kurzfristige Änderungen der Daten nicht mehr berücksichtigt werden. Aufgrund der zu erwartenden Änderungshäufigkeit der zu schreibenden Daten ist diese Vorgehensweise nicht sinnvoll. Dies würde zu erheblichen Mehrkosten führen, da ganze Chargen mit Speicherbausteinen unbrauchbar wären und wieder zum Hersteller zurückgeschickt werden müssten. Auch die zeitliche Verzögerung bei notwendigen Änderungen wäre nicht akzeptabel.

Ein weiterer Nachteil, den das oben genannte Verfahren aufweist besteht darin, dass die Speicherbausteine vor der Bestückung der Platinen programmiert werden und nur dabei überprüft werden können.

Die einwandfreie Funktionsweise der vollständigen Speichermodule kann jedoch erst nach dem Lötvorgang, der dem Bestücken folgt, getestet werden. Fehler die beim Lötvorgang auftreten können, müssen somit in einem zusätzlichen Arbeitsschritt geprüft werden.

US 5 157 829 beschreibt ein Verfahren, bei dem ein Einbrenntest an elektronischen Schaltungen durchgeführt wird, die sich auf einer gemeinsamen Trägerplatine befinden. Nach dem Einbrenntest werden die Schaltungen in einzelne Module getrennt.

Die Aufgabe der Erfindung besteht darin, ein einfaches Verfahren zur Herstellung von Speichermodulen anzugeben, das effektiv, schnell und zuverlässig ist und das für schnelle Ferrigungsprozesse geeignet ist.

Gelöst wird diese Aufgabe durch die im Anspruch 1 angegebenen Verfahrensmerkmale.

Vorteilhafte Weiterentwicklungen der Erfindung sind in den Unteransprüchen angegeben.

Die wesentliche Idee der Erfindung besteht darin, die Speicherbausteine nicht mehr während des Bestückungsvorgangs zu programmieren, sondern eine Trägerplatine mit mehreren Speicherbausteinen zu bestücken und die Speicherbausteine erst nach der Bestückung der separaten Trägerplatine zu programmieren. Anschließend wird die Trägerplatine in einzelne Speichermodule mit bereits programmierten Speicherbausteinen getrennt. Diese beschriebenen Speichermodule können schnell und einfach in einem weiteren Fertigungsschritt bei der Komplettierung der Elektronikmodule bzw. bei der Endmontage der Messumformer eingesetzt werden.

Zur Programmierung einzelner Speichermodule der Trägerplatine wird ein auf der Trägerplatine vorgesehenes Bussystem verwendet, welches die Ansteuerung aller darauf angebrachten Speicherbausteine ermöglicht.

Zur Programmierung der einzelnen Speichermodule umfasst das Bussystem in vorteilhafter Weise einen Adress-, Daten- und Steuerbus.

Zusätzlich weist das Bussystem noch einen Adressdekoder auf.

In einer Weiterentwicklung der Erfindung handelt es sich bei den Speicherbausteinen um sogenannte Flash-Memory-Speicher (Flash-Speicherbausteine).

In einer Weiterentwicklung der Erfindung werden die Speichermodule aus der Trägerplatine gestanzt oder gesägt, bevor sie eingesetzt werden.

Die zur Durchführung des erfindungsgemäßen Verfahrens benötigte Trägerplatine weist ein Bussystem auf, das einzelne Segmente der Platine verbindet.

Nachfolgend ist die Erfindung anhand eines in der Zeichnung dargestellten Ausführungsbeispiels näher erläutert.

Es zeigt:

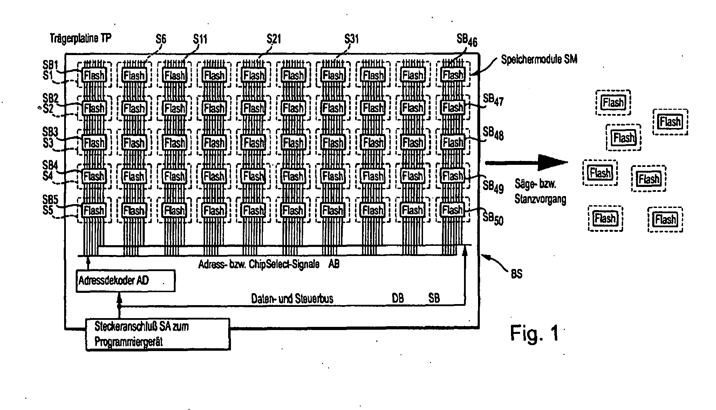

Fig. 1 erfindungsgemäße Trägerplatine mit

mehreren Speichermodulen.

Fig. 1 zeigt eine Trägerplatine TP mit mehreren Speichermodulen SM (insgesamt 50) nach dem Bestückungs- und Lötvorgang der Platine. Jedes Speichermodul SMᵢ ,i= 1-50, gehört zu einem speziellen Segment Sᵢ ,i= 1-50, auf der Trägerplatine TP. Der Übersichtlichkeit halber sind nicht alle 50 Speichermodule bzw. alle 50 Segmente beziffert.

Die einzelnen Segmente Sᵢ sind über ein Bussystem BS miteinander verbunden. Das Bussystem BS umfasst einen Adressbus AB, einen Datenbus DB sowie einen Steuerbus SB. Weiterhin umfasst das Bussystem BS einen Adressdekoder AD, der mit dem Adressbus AB verbunden ist. Der Adressdekoder ermöglicht eine Selektierung nach dem Schema "1-aus-n" - es können dadurch eine große Anzahl von Busteilnehmern (in diesem Fall Speicherbausteine) mit nur einer geringen Anzahl von Adresssignalen angesteuert werden.

Zur Verbindung mit einem Programmiergerät dient ein Steckeranschluss SA an der Trägerplatine TP.

Weitere Komponenten die auf den Speichermodulen angeordnet sind, wie z. B. ESD-Schutzschaltungen sind der Übersichtlichkeit halber nicht eingezeichnet.

Derartig segmentierte Trägerplatinen werden häufig auch als Nutzen bezeichnet.

Nachfolgend ist das erfindungsgemäße Verfahren näher erläutert. Die Trägerplatine TP wird in herkömmlicher Weise mit Speicherbausteinen SB bestückt. Erst nach dem Lötvorgang werden die Speicherbausteine SB programmiert. Hierzu wird über den Steckeranschluss SA ein entsprechendes Programmiergerät mit der Trägerplatine TP verbunden. Anschließend werden einzelne Speicherbausteine SB mit Daten beschrieben. Dieser Vorgang wird auch als Programmieren bezeichnet.

Über das auf der Trägerplatine TP vorgesehene Bussystem BS können die Daten zu den einzelnen Speichermodulen SM übertragen werden. Treten bei der Programmierung einzelner Speicherbausteine SB Probleme auf, so werden diese als defekt erkannt. Die Fehlererkennung wird durch den für die Speicherbausteine SB zwangsläufig erforderlichen Programmieralgorithmus realisiert. Vor der Bestückung der Elektronikkomponenten eines Messumformers werden die einzelnen Speichermodule SM dann aus der Trägerplatine TP ausgestanzt bzw. ausgesägt. Anschließend können sie einzeln einem Bestückungsautomaten zugeführt werden.

Der wesentliche Vorteil des Verfahrens besteht darin, dass der für die Verzögerungen beim Bestückungsvorgang verantwortliche Prograrnmiervorgang auf einen späteren, unkritischen Zeitpunkt, verlagert werden kann. Die bei der Fertigung verwendeten Bestückungsautomaten können so optimal genutzt werden. Statt auf die Programmierung eines Speicherbausteins zu warten, können weitere bzw. andere Platinen bestückt werden. Verzögerungen aufgrund des Programmiervorgangs treten bei der Montage eines Speicherbausteins nicht mehr auf; hierdurch wird der Durchsatz maximiert und damit die Gesamtproduktionskosten gesenkt.

Zusätzlich ist durch die zeitliche Trennung zwischen Bestückungsvorgang und Programmierung eine Produktion von Speichermodulen "auf Halde" möglich. Die für die Fertigstellung eines Produkts erforderlichen Daten können unmittelbar vor dem Zusammenbau programmiert werden.

Für die Durchführung des erfindungsgemäßen Verfahrens ist eine Trägerplatine TP notwendig, auf der ein entsprechendes Bussystem BS vorgesehen ist. Ein solches Bussystem BS kann relativ kostengünstig bei der Herstellung der Trägerplatine TP in diese integriert werden.

Nach dem Zerteilen der Trägerplatine TP in die einzelnen Speichermodule SM ist das Bussystem unbrauchbar. Der Teil der Trägerplatine mit dem Adressdekoder AD bzw dem Steckeranschluss SA wird als Elektronikabfall entsorgt.

Ein weiterer Vorteil den das erfindungsgemäße Verfahren bietet, besteht darin, dass mehrere Trägerplatinen TP zugleich an ein Programmiergerät angeschlossen werden können. Somit vervielfacht sich die Anzahl der Speicherbausteine SB, die gleichzeitig programmiert werden können.

Bezugszeichenliste

**Tabelle 1**

| | |
|---|---|
| Adressbus | AB |
| Adressdekoder | AD |
| Bussystem | BS |
| Datenbus | DB |
| Segment | Sᵢ |
| Speichermodulen | SMᵢ |
| Steckeranschluss | SA |
| Steuerbus | SB |
| Trägerplatine | TP |

## Patentansprüche

1. Verfahren zur Herstellung von Speichermodulen (SM) **gekennzeichnet durch** folgende Verfahrensschritte:
a. Bestückung einer Trägerplatine (TP), die in mehrere Segmente unterteilt ist, mit Speicherbausteinen, wobei die Speichermodule jeweils aus einem Segment mit einem Speicherbaustein gebildet werden,
b. Programmieren einzelner Speicherbausteine über ein auf der Trägerplatine (TP) vorgesehenes Bussystem (BS), wobei die Speicherbausteine nach einem Bestückungs-und Lötvorgang der Trägerplatine (TP) programmiert werden,
c. Trennen der Trägerplatine (TP) nach dem Programmieren der Speicherbausteine in einzelne programmierte Speichermodule.

2. Verfahren nach dem vorhergehenden Anspruch, **dadurch gekennzeichnet, dass** einzelne Speicherbausteine mit Daten beschrieben werden.

3. Verfahren nach einem der vorhergehenden Ansprüche, **dadurch gekennzeichnet, dass** die beschriebenen Speichermodule bei der Komplettierung von Elektronikmoduln, insbesondere bei der Endmontage von Messumformem, eingesetzt werden.

4. Verfahren nach Anspruch 1, **dadurch gekennzeichnet, dass** das Bussystem (BS) einen Adressbus (AB), Datenbus (DB) und Steuerbus (SB) umfasst.

5. Verfahren nach Anspruch 2, **dadurch gekennzeichnet, dass** das Bussystem (BS) über einen Adressdekoder verfügt.

6. Verfahren nach einem der vorhergehenden Ansprüche 1-3, **dadurch gekennzeichnet, dass** die Speicherbausteine Flash-Memory-Speicher sind.

7. Verfahren nach Anspruch 5, **dadurch gekennzeichnet, dass** die Speichermodule aus der Trägerplatine (TP) gestanzt oder gesägt werden.

## Claims

1. Method for producing memory modules (SM), **characterized in that** the method comprises the following steps:
a. Equipping a carrier board (TP), which is split into several segments, with memory modules, where each memory module is made from one segment with one memory module.
b. Programming individual memory modules via a bus system (BS) provided on the carrier board (TP), where the memory modules are programmed after equipping and soldering the carrier board.
c. Separating the carrier board (TP) into individual programmed memory modules after programming the memory modules.

2. Method as per the previous claim, **characterized in that** data are written to the individual memory modules.

3. Method as per one of the previous claims, **characterized in that** the written memory modules are deployed when completing electronic modules, particularly during final transmitter assembly.

4. Method as per Claim 1, **characterized in that** the bus system (BS) comprises an address bus (AB), a data bus (DB) and a control bus (SB).

5. Method as per Claim 2, **characterized in that** the bus system (BS) has an address decoder.

6. Method as per one of the previous Claims 1-3, **characterized in that** the memory modules are flash memory units.

7. Method as per Claim 5, **characterized in that** the memory modules are punched or sawn out of the carrier board (TP).

## Revendications

1. Procédé destiné à la fabrication de modules mémoire (SM), **caractérisé par** les étapes de procédé suivantes :
a. Équipement d'une platine-support (TP), laquelle est scindée en plusieurs segments, dotée de composants mémoire, les modules mémoire étant chacun constitués d'un segment doté d'un composant mémoire,
b. Programmation de composants mémoire individuels par l'intermédiaire d'un système de bus (BS) prévu sur la platine-support (TP), les composants mémoire étant programmés d'après un processus de soudage suivant l'équipement,
c. Séparation de la platine-support (TP) après la programmation des composants mémoire en modules mémoire programmés.

2. Procédé selon la revendication précédente, **caractérisé en ce que** les différents modules mémoire sont écrits de données.

3. Procédé selon l'une des revendications précédentes, **caractérisé en ce que** les modules mémoire écrits sont utilisés pour l'assemblage de modules électroniques, notamment pour le montage final de transmetteurs.

4. Procédé selon la revendication 1, **caractérisé en ce que** le système de bus (BS) comprend un bus d'adresses (AB), un bus de données (DB) et un bus de commande (BS).

5. Procédé selon la revendication 2, **caractérisé en ce que** le système de bus (BS) dispose d'un décodeur d'adresses.

6. Procédé selon l'une des revendications précédentes 1 à 3, **caractérisé en ce que** les modules mémoire sont des mémoires flash.

7. Procédé selon la revendication 5, **caractérisé en ce que** les modules mémoire sont estampés ou sciés à partir de la platine-support (TP).
